(19) **Europäisches Patentamt / European Patent Office / Office européen des brevets**

(11) **EP 2 288 027 A2**

(12) **EUROPEAN PATENT APPLICATION**

(43) Date of publication:
**23.02.2011 Bulletin 2011/08**

(51) Int Cl.:
***H03H 9/02*** *(2006.01)*

(21) Application number: **10006770.1**

(22) Date of filing: **30.06.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(30) Priority: **17.08.2009 JP 2009188475**

(71) Applicant: **Hitachi Media Electronics Co., Ltd.**
**Oshu-shi, Iwate 0230841 (JP)**

(72) Inventors:
• **Isobe, Atsushi**
**Tokyo 100-8220 (JP)**
• **Asai, Kengo**
**Tokyo 100-8220 (JP)**

(74) Representative: **Strehl Schübel-Hopf & Partner**
**Maximilianstrasse 54**
**80538 München (DE)**

(54) **Elastic wave device**

(57)    In a boundary elastic wave resonator formed with a cross finger type transducer (IDT) of a wave length λ of a boundary elastic wave, a silicon oxide film (5), and an aluminum nitride film (6) above a surface of a θYX-LN single-crystal piezoelectric substrate (1) having a predetermined cut angle θ, a film thickness $h_1$ and a cut angle θ or the like of the silicon oxide film are optimized. For example, the film thickness $h_1$ and the cut angle θ are made to be $127.5° \leq θ \leq 129.5°$ and $20\% \leq h_1/\lambda \leq 100\%$.

# FIG. 1

## Description

### FIELD OF THE INVENTION

The present invention relates to an elastic wave device, particularly, relates to a technology which is effective by being applied to a boundary elastic wave device having a piezoelectric substance and a cross-finger type Inter-Digital Transducer (IDT) for a boundary elastic wave, and constituting a solid circuit element of a resonator, a filter or the like of a communication apparatus for a high frequency.

### BACKGROUND OF THE INVENTION

A boundary elastic wave device is small-sized and is provided with an excellent temperature stability because the boundary elastic wave device can dispense with a hollow package, and because the boundary elastic wave device can use silicon oxide as a temperature compensating film.

For example, in International Patent Publication WO 98/052279 pamphlet (Patent document 1), there are disclosed a relationship between a propagation loss and a cut angle and a relationship between a propagation loss and a film thickness of a polycrystalline silicon film in a boundary elastic wave resonator which is provided with IDT, a silicon oxide film, and a polycrystalline silicon film above a substrate whose major component is constituted by lithium niobate piezoelectric single crystal, which is cut out in θ rotation Y cut, and in which a propagation direction of an elastic wave is made to be X-axis direction (hereinafter, abbreviated as θYX-LN single-crystal piezoelectric substrate) with a leakage boundary elastic wave as an object. Further, it is also disclosed that an aluminum nitride film can be used in place of the polycrystalline silicon film.

Further, in JP-A-Hei10(1998)-84247 (Patent document 2), there is disclosed a relationship between a propagation loss and a cut angle in a boundary elastic wave device which is provided with IDT, a silicon oxide film, and a single-crystal silicon substrate above a θYX-LN single-crystal piezoelectric substrate with a leakage boundary elastic wave as an object.

Further, in International Patent Publication WO 05/069485 pamphlet (Patent document 3), and International Patent Publication WO 06/114930 pamphlet (Patent document 4), there is disclosed a boundary elastic wave device having a small propagation loss with a boundary elastic wave as an object.

Further, in J. J. Campbell and W. R. Jones, "A method for estimating optical cuts and propagation directions for excitation of piezoelectric surface waves", IEEE Trans. Sonics and Ultrason., Vol. SU-15, pp. 209-217 (1968)(Non-patent document 1), there is reported a method of predicting a propagation loss of a boundary elastic wave.

### SUMMARY OF THE INVENTION

Generally, a high quality factor (Q value) and an easiness of fabrication are requested for a high frequency filter. Particularly, a Q value equal to or higher than several thousands is requested for use of a communication apparatus represented by a portable telephone.

In IDT investigated by the inventors, a main boundary elastic wave which is excited/resonated in IDT is a leakage boundary elastic wave. In a boundary elastic wave resonator, a Stoneley wave type boundary elastic wave, a slow transverse bulk wave, a fast transverse bulk wave, and a longitudinal bulk wave are generated as spurious elastic waves. In a boundary elastic wave resonator constituting IDT by a metal having a small density, a leakage boundary elastic wave is provided with a sound speed between a sound speed of a slow transverse bulk wave and a sound speed of a fast transverse bulk wave. The leakage boundary elastic wave is provided with a sound speed substantially between 4000 through 4800 m/s. That is, there are generated the slow transverse bulk wave comparatively near to a low frequency side, the Stoneley wave type boundary elastic wave on a lower frequency wave side, the fast transverse bulk wave comparatively near to a high frequency side, and the longitudinal bulk wave to a higher frequency side. Therefore, when a high frequency filter is realized, it is necessary to suppress the slow transverse bulk wave and the fast transverse bulk wave generated near to a main signal. Further, when an electric characteristic of the boundary elastic wave resonator using the θYX-LN single-crystal piezoelectric substrate is investigated, there is obtained a result that the slow transverse bulk wave is at a vicinity of the sound speed of 4000 m/s, therefore, the slow transverse bulk wave is generated immediately below a series resonance frequency of the leakage boundary elastic wave, and is strongly coupled with IDT. The smaller the difference between sound speeds of the slow transverse bulk wave and the leakage boundary elastic wave, the more adverse influence is effected on a filter characteristic, and therefore, in order to realize a high frequency filter, it is necessary that the leakage boundary elastic wave is constituted by a sound speed sufficiently higher than the sound speed of the slow transverse bulk wave.

Further, a main boundary elastic wave which is excited/resonated in IDT on which the inventors are investigating is a leakage boundary elastic wave, and is provided with an elastic propagation loss. Therefore, in order to achieve a sufficiently high Q value in a boundary elastic wave device, it is necessary to minimize a propagation loss of IDT (maximize an elastic Q value) by optimizing a structure of a boundary elastic wave resonator of a material, a film thickness, a cut angle, and the like.

Further, in a UMTS portable telephone system, there is needed a branching filter having a steep filter characteristic at RF band. There are various bands from band 2 having the narrowest transmission/reception interval (transmission/reception interval about 1%) to band 4 having the widest transmission/reception interval (transmission/reception interval about 17%), and there is needed a boundary elastic wave having an electromechanical coupling factor (hereinafter, abbreviated as k2) adapted to these bands..When k2 coincides with twice as much as the transmission/reception interval, the steepest filter characteristic can be realized. For example, the boundary elastic wave described in Patent documents 1 and 2, mentioned above, has large k2 equal to or larger than 8%. However, although a boundary elastic wave having k2 of 2 through 8% is needed, the boundary elastic wave having k2 of 2 through 8% has not been realized yet.

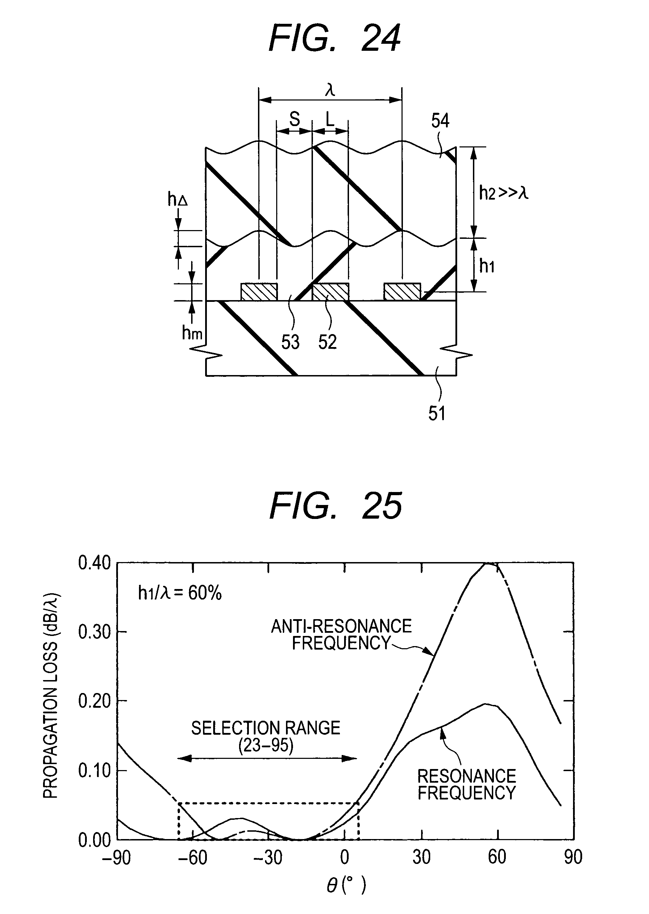

In Patent document 1 described above, in a boundary elastic wave resonator which is provided with IDT 52, a silicon oxide film 53, and a polycrystalline silicon film 54 above a $\theta$YX-LN single-crystal piezoelectric substrate 51 as shown by Fig. 24, values of a cut angle $\theta$ and a film thickness $h_1$ of the polycrystalline silicon film by which an elastic Q value becomes equal to or larger than a thousand (a range in which a propagation loss is equal to or smaller than 0.056dB) are described as shown by Fig. 25 (Fig. 10C of Patent document 1 described above). That is, there is disclosed a boundary elastic wave device in which $0.585\lambda{\le}h_1$ and $23°{\le}\theta{\le}95°$ ($103°{\le}\theta{\le}185°$ in a description of the present invention). Here, notation $\lambda$ designates a wave length of a boundary elastic wave. However, in this range in which the Q value is made to be equal to or larger than a thousand as the premise, a sufficient accuracy is not achieved in a high frequency filter of, for example, 2GHz class the use of which is represented by a communication apparatus in recent times.

Further, the polycrystalline silicon film constituting an object in Patent document 1 described above has an electrical conductivity and a low resistance value. Therefore, even when values of the cut angle $\theta$ and the film thickness $h_1$ of the polycrystalline silicon film shown in Fig. 25 are used as they are, the elastic Q value cannot be increased up to about several thousands through ten thousands requested in a boundary elastic wave device in recent times.

Further, on page 12 of Patent document 1 described above, it is also disclosed that an aluminum nitride film can be used in place of the polycrystalline silicon film. However, there is not described a relationship between the cut angle $\theta$ and the film thickness $h_1$ of the polycrystalline silicon film by which an elastic Q value in a boundary elastic wave resonator using the aluminum nitride film becomes equal to or larger than several thousands. An elastic constant of a film whose major component is a nitride substance represented by aluminum nitride or silicon nitride is remarkably larger than an elastic constant of the polycrystalline silicon film, and therefore, it is impossible to predict the relationship from the description with regard to the polycrystalline silicon film of Patent document 1 described above by analogy.

Further, in Patent document 2 described above, a single-crystal silicon substrate is used at the topmost layer, the single-crystal silicon substrate has an electrical conductivity and a low resistance, and therefore, the Q value of the boundary elastic wave device cannot be increased. Further, a special fabrication apparatus is needed in order to form the single-crystal silicon substrate at the topmost layer, and therefore, there poses a problem of an increase in cost, an increase in TAT or the like in fabrication thereof.

It is an object of the present invention to provide a technology which can realize a boundary elastic wave device which has a high quality factor (Q value is equal to or larger than several thousands), and in which k2 falls in a range of 2 through 6%.

Further, it is another object of the present invention to provide a technology which can easily fabricate a boundary elastic wave device which has a high quality factor (Q value is equal to or larger than several thousands) and in which k2 falls in a range of 2 through 6%.

The above-described objects as well as other object and a novel characteristic of the present invention become apparent from a description and attached drawings of the specification.

A simple explanation will be given of an embodiment of a representative one of the invention disclosed in the present application as follows.

The embodiment is an elastic wave device which has a boundary elastic wave resonator which is provided with IDT, a silicon oxide film, and a polycrystalline silicon film above a $\theta$YX-LN single-crystal piezoelectric substrate whose major component is constituted by a lithium niobate piezoelectric single crystal, which has a plane cut out in $\theta$ rotation Y cut, and in which a propagation direction of an elastic wave is constituted by a direction in parallel with X-axis.

IDT mainly excites a boundary elastic wave, when a wave length of the boundary elastic wave is designated by a notation $\lambda$, a thickness of the silicon oxide film is designated by a notation $h_1$, and a thickness of IDT is designated by a notation $h_m$, an inequality of $1\% \le h_m/\lambda \le 8\%$ is established, and the elastic wave device is characterized in conforming to one of a group of inequalities of $124.5° \le \theta < 125.5°$ and $20\% \le h_1/\lambda \le 45\%$, $125.5° \le \theta < 126.5°$ and $20\% \le h1/\lambda \le 45\%$, $126.5° \le \theta < 127.5°$ and $20\% \le h_1/\lambda \le 47\%$, $126.5° \le \theta < 127.5°$ and $87\% \le h_1/\lambda \le 100\%$, $127.5° \le \theta < 128.5°$ and $20\% \le h1/\lambda \le 100\%$, $128.5° \le \theta < 129.5°$ and $20\% \le h1/\lambda \le 100\%$, $129.5° \le \theta < 130.5°$ and $20\% \le h_1/\lambda \le 75\%$, $130.5° \le \theta < 131.5°$ and $20\% \le h_1/\lambda \le 61\%$, and $131.5° \le \theta \le 132.5°$ and $33\% \le h_1/\lambda \le 57\%$.

Further, IDT mainly excites a boundary elastic wave, when a wave length of the boundary elastic wave is designated by a notation $\lambda$, a thickness of the silicon oxide film is designated by a notation $h_1$, and a thickness of IDT is designated by a notation $h_m$, an inequality of $1\% \le h_m/\lambda \le 8\%$ is established, and the elastic wave device is characterized in conforming to one of a group of inequalities of $124.5° \leq \theta < 125.5°$ and $55\% \leq h_1/\lambda \leq 73\%$, $125.5° \leq \theta < 126.5°$ and $59\% \leq h_1/\lambda \leq 83\%$, $126.5° \leq \theta < 127.5°$ and $63\% \leq h_1/\lambda \leq 100\%$, $127.5° \leq \theta < 128.5°$ and $67\% \leq h_1/\lambda \leq 100\%$, $128.5° \leq \theta < 129.5°$ and $75\% \leq h_1/\lambda \leq 100\%$, $129.5° \leq \theta < 130.5°$ and $85\% \leq h_1/\lambda \leq 100\%$, $130.5° \leq \theta \leq 131.5°$ and $93\% \leq h_1/\lambda \leq 100\%$, and $131.5° \leq \theta \leq 132.5°$ and $95\% \leq h_1/\lambda \leq 100\%$.

A simple explanation will be given of an advantage achieved by an embodiment of a representative one of the invention disclosed in the application as follows.

A boundary elastic wave device which has a high quality factor (Q value is equal to or larger than several thousands), and in which the k2 falls in a range of 2 through 6% can be realized. Further, a boundary elastic wave device which has a high quality factor (Q value is equal to or larger than several thousands), and in which k2 falls in a range of 2 through 6% can easily be fabricated.

BRIEF DESCRIPTION OF THE DRAWINGS

Fig. 1 is a plane view of an essential portion of a boundary elastic wave resonator according to a first embodiment of the present invention;

Fig. 2 is a sectional view of an essential portion taken along a line I-I' of Fig. 1;

Fig. 3 is a view for explaining a film thickness of an electrode finger, a film thickness of a silicon oxide film, a film thickness of an aluminum nitride film, an amount of undulations of an interface, a line width of the electrode finger, an interval between the electrode fingers, and a definition of a wave length of a boundary elastic wave excited according to the first embodiment of the present invention;

Fig. 4 is a model diagram used in analyzing a boundary elastic wave resonator of a 3 media structure according to the first embodiment of the present invention;

Figs. 5A and 5B are respectively a graph diagram showing a relationship between 1/Q and $h_1/\lambda$ and a graph diagram showing a relationship between k2 and $h_1/\lambda$ of the boundary elastic wave resonator according to the first embodiment of the present invention in a case of $\theta = 125°$;

Figs. 6A and 6B are respectively a graph diagram showing a relationship between 1/Q and $h_1/\lambda$ and a graph diagram showing a relationship between k2 and $h_1/\lambda$ of the boundary elastic wave resonator according to the first embodiment of the present invention in a case of $\theta = 126°$;

Figs. 7A and 7B are respectively a graph diagram showing a relationship between 1/Q and $h_1/\lambda$ and a graph diagram showing a relationship between k2 and $h_1/\lambda$ of the boundary elastic wave resonator according to the first embodiment of the present invention in a case of $\theta = 127°$;

Figs. 8A and 8B are respectively a graph diagram showing a relationship between 1/Q and $h_1/\lambda$ and a graph diagram showing a relationship between k2 and $h_1/\lambda$ of the boundary elastic wave resonator according to the first embodiment of the present invention in a case of $\theta = 128°$;

Figs. 9A and 9B are respectively a graph diagram showing a relationship between 1/Q and $h_1/\lambda$ and a graph diagram showing a relationship between k2 and $h_1/\lambda$ of the boundary elastic wave resonator according to the first embodiment of the present invention in a case of $\theta = 129°$;

Figs. 10A and 10B are respectively a graph diagram showing a relationship between 1/Q and $h_1/\lambda$ and a graph diagram showing a relationship between k2 and $h_1/\lambda$ of the boundary elastic wave resonator according to the first embodiment of the present invention in a case of $\theta = 130°$;

Figs. 11A and 11B are respectively a graph diagram showing a relationship between 1/Q and $h_1/\lambda$ and a graph diagram showing a relationship between k2 and $h_1/\lambda$ of the boundary elastic wave resonator according to the first embodiment of the present invention in a case of $\theta = 131°$;

Figs. 12A and 12B are respectively a graph diagram showing a relationship between 1/Q and $h_1/\lambda$ and a graph diagram showing a relationship between k2 and $h_1/\lambda$ of the boundary elastic wave resonator according to the first embodiment of the present invention in a case of $\theta = 132°$;

Fig. 13 is a graph diagram showing a range of $h_1/\lambda$ and a cut angle $\theta$ in which a boundary elastic wave according to a second embodiment of the present invention is present;

Fig. 14 is a graph diagram showing k2 of a boundary elastic wave of a boundary elastic wave resonator according to the second embodiment of the present invention in a case of $h_1/\lambda = 10\%$;

Fig. 15 is a graph diagram showing k2 of the boundary elastic wave of the boundary elastic wave resonator according to the second embodiment of the present invention in a case of $h_1/\lambda = 20\%$;

Fig. 16 is a graph diagram showing k2 of the boundary elastic wave of the boundary elastic wave resonator according to the second embodiment of the present invention in a case of $h_1/\lambda = 30\%$;

Fig. 17 is a graph diagram showing k2 of the boundary elastic wave of the boundary elastic wave resonator according to the second embodiment of the present invention in a case of $h_1/\lambda = 40\%$;

Fig. 18 is a graph diagram showing k2 of the boundary elastic wave of the boundary elastic wave resonator according to the second embodiment of the present invention in a case of $h_1/\lambda = 50\%$;

Fig. 19 is a graph diagram showing k2 of the boundary elastic wave of the boundary elastic wave resonator according to the second embodiment of the present invention in a case of $h_1/\lambda = 60\%$;

Fig. 20 is a graph diagram showing k2 of the boundary elastic wave of the boundary elastic wave resonator according to the second embodiment of the present invention in a case of $h_1/\lambda$ = 70%;

Fig. 21 is a graph diagram showing k2 of the boundary elastic wave of the boundary elastic wave resonator according to the second embodiment of the present invention in a case of $h_1/\lambda$ = 80%;

Fig. 22 is a graph diagram showing k2 of the boundary elastic wave of the boundary elastic wave resonator according to the second embodiment of the present invention in a case of $h_1/\lambda$ = 90%;

Fig. 23 is a graph diagram comparing a reflectance of a short-circuit type reflector and a reflectance of an open type reflector;

Fig. 24 is a sectional view of an essential portion showing an example of a boundary elastic wave resonator on which the inventors have investigated; and

Fig. 25 is a graph diagram showing a range of a cut angle θ in which an elastic Q value becomes equal to or larger than a thousand (a propagation loss falls in a range equal to or smaller than 0.056dB), which has been investigated by the inventors.

DETAILED DESCRIPTION OF THE PREFERRED EMBODIMENTS

In the following embodiments, although an explanation will be given by dividing an embodiment into plural sections or embodiments when it is necessary for convenience, except a case of being clearly indicated particularly, these are not unrelated to each other, but one of them is brought into a relationship of a modified example, details, a supplementary explanation or the like of a portion or a total of the other.

Further, in the following embodiments, in a case of referring to a number of elements or the like (including a number of pieces, a numerical value, an amount, a range or the like), except a case of being clearly indicated particularly and a case of being limited to a specific number clearly in principle or the like, an embodiment is not limited to the specific number, but may be equal to or larger or equal to or smaller than the specific number. Further, in the following embodiments, a constituent element thereof (including an element step or the like) is not necessarily indispensable naturally, except a case of being clearly indicated particularly and a case of being conceived to be indispensable clearly in principle or the like. Similarly, in the following embodiments, when referring to a shape, a positional relationship or the like of a constituent element or the like, these include what is approximate to or similar to the shape or the like substantially except a case of being clearly indicated particularly and a case of being conceived to be not so clearly in principle or the like. The same goes with the numerical value and the range described above.

Further, in total views for explaining the following embodiments, what has the same function is attached with the same notation as a rule, and a repetitive explanation thereof will be omitted. A detailed explanation will be given of embodiments of the present invention in reference to the drawings as follows.

First Embodiment

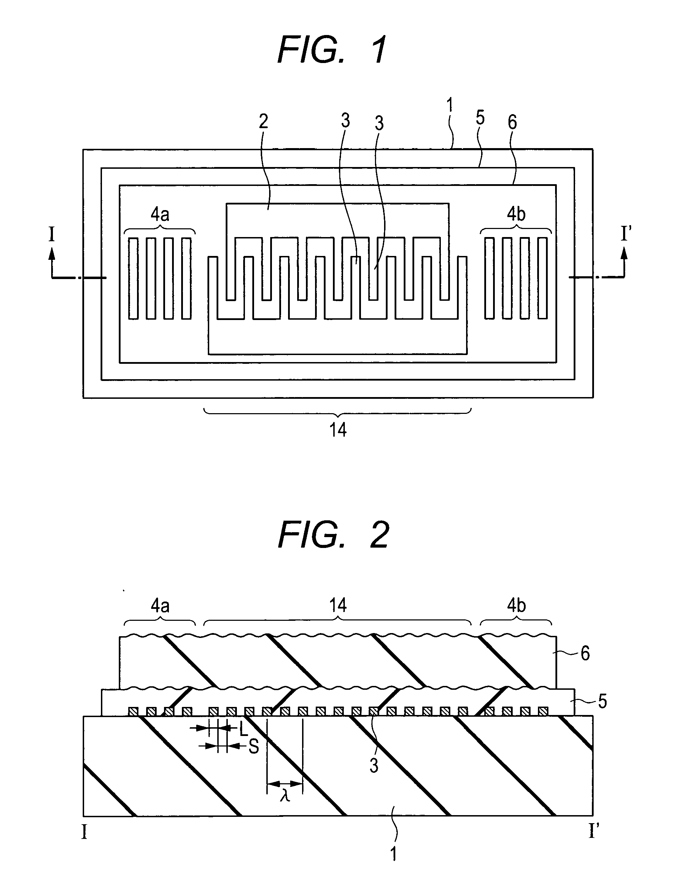

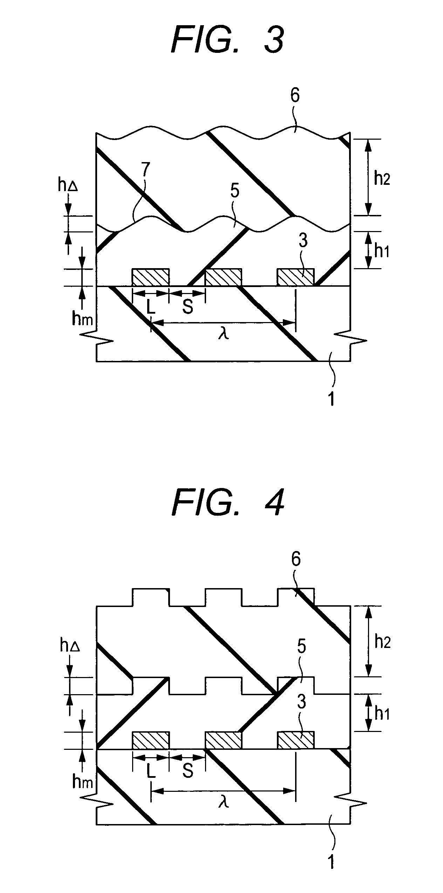

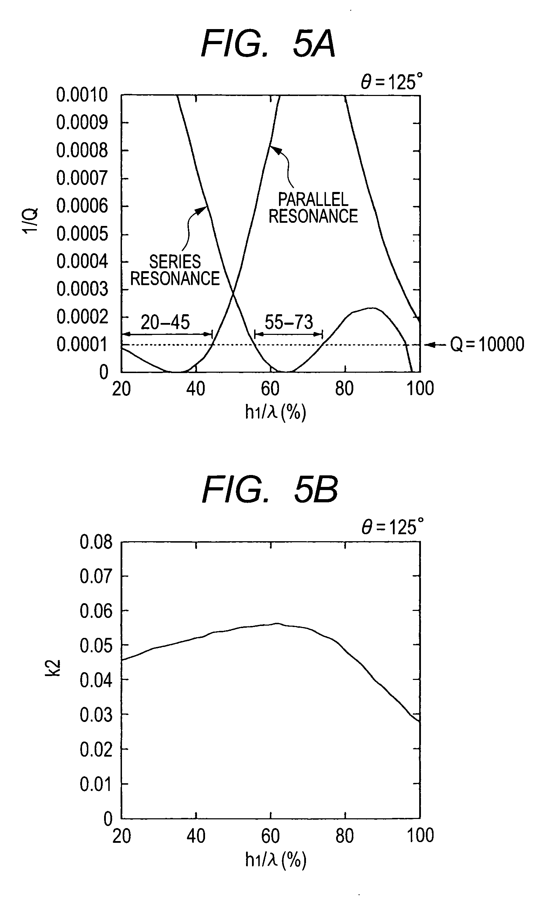

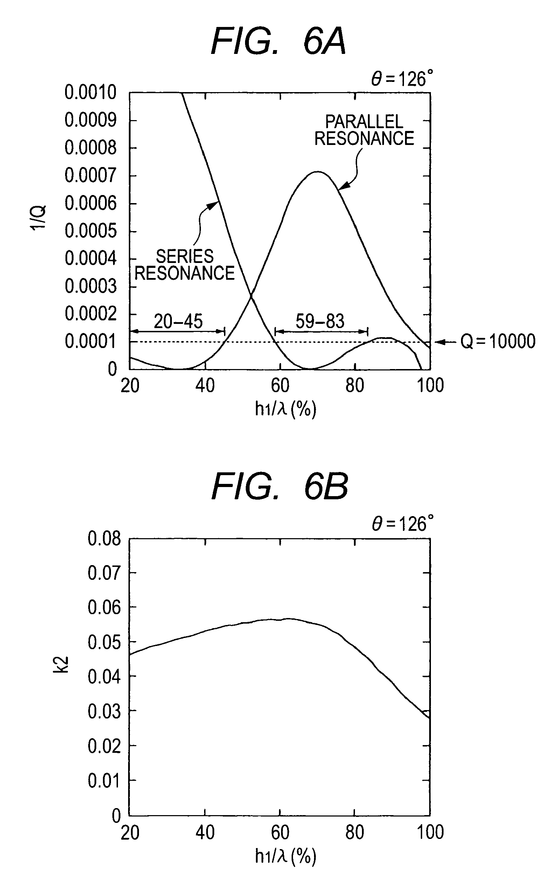

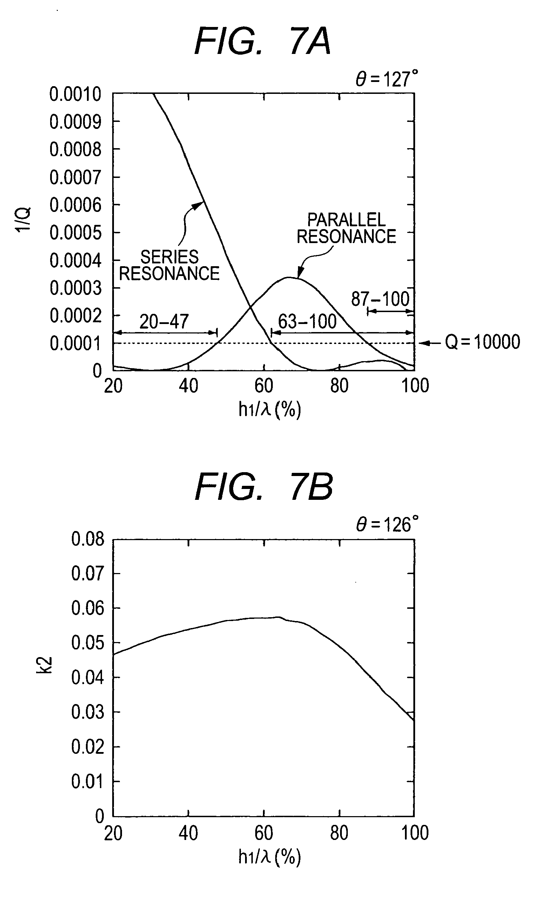

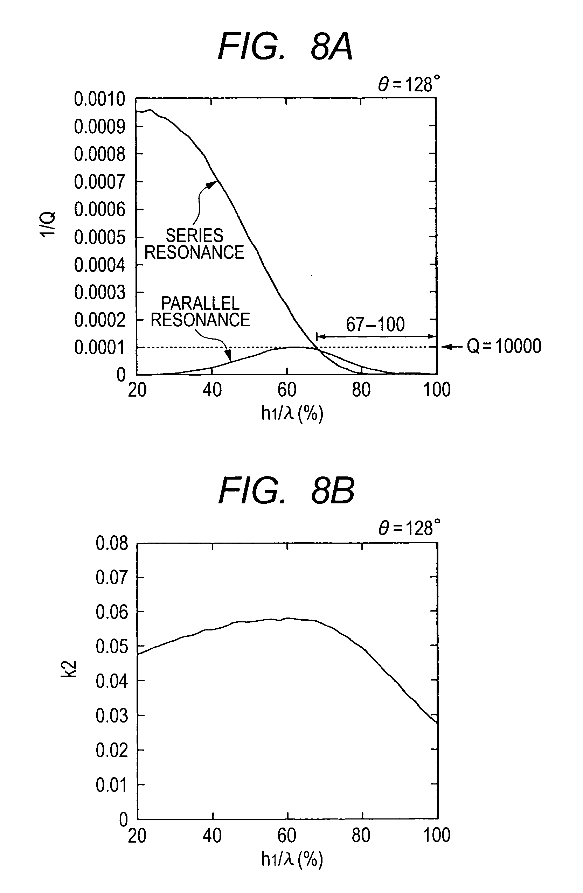

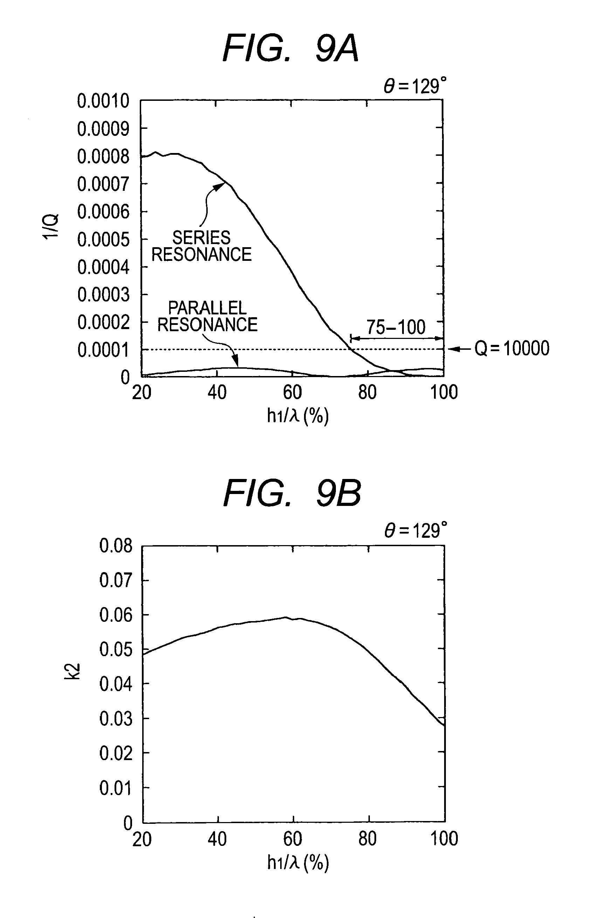

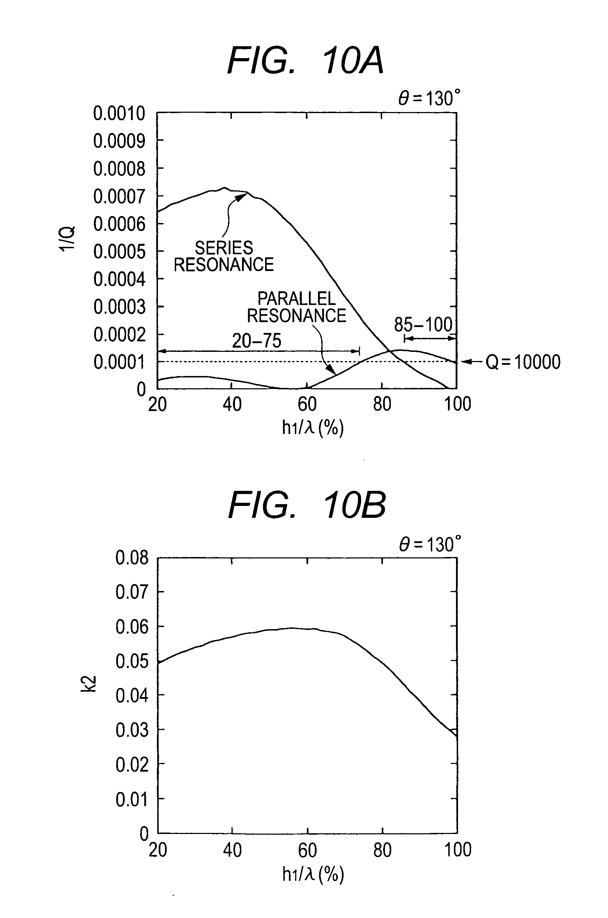

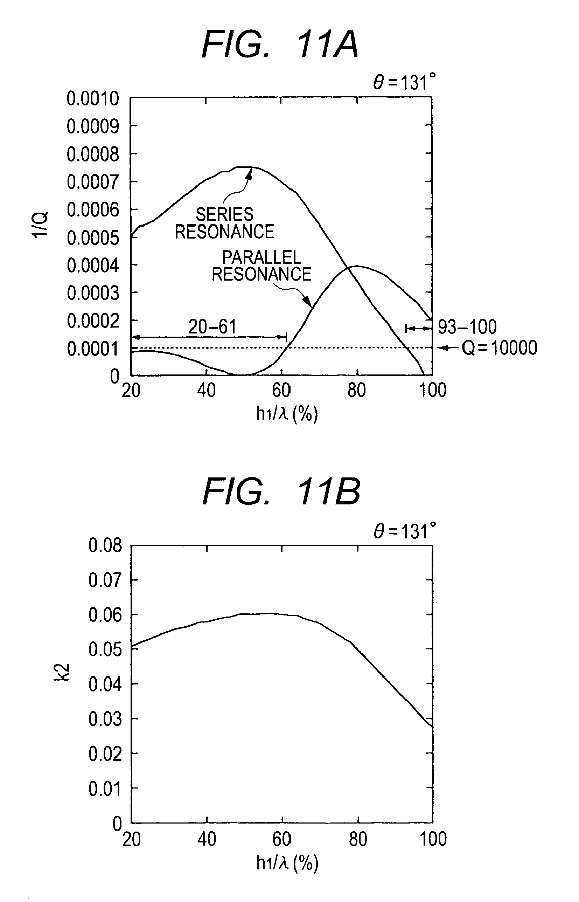

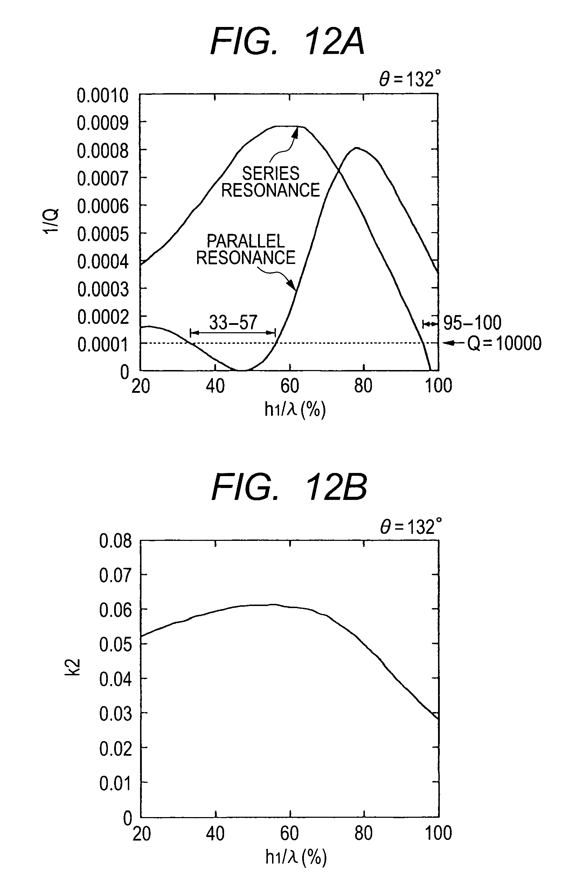

An explanation will be given of a boundary elastic wave device according to the first embodiment in reference to Fig. 1 through Fig. 12. Fig. 1 is a plane view of an essential portion of a boundary elastic wave resonator, Fig. 2 is a sectional view of an essential portion taken along a line I-I' of Fig. 1, Fig. 3 is a view for explaining a film thickness of an electrode finger, a film thickness of a silicon oxide film, a film thickness of an aluminum nitride film, an amount of undulations of an interface, a line width of the electrode finger, an interval of the electrode fingers, and a definition of a wave length of the boundary elastic wave excited, Fig. 4 is a model diagram used in analyzing a boundary elastic wave resonator of a 3 media structure, Figs. 5A and 5B are graph diagrams showing a propagation characteristic of the boundary elastic wave in a case of θ = 125°, Figs. 6A and 6B are graph diagrams showing the propagation characteristic of the boundary elastic wave in a case of θ = 126°, Figs. 7A and 7B are graph diagrams showing the propagation characteristic of the boundary elastic wave in a case of θ = 127°, Figs. 8A and 8B are graph diagrams showing the propagation characteristic of the boundary elastic wave in a case of θ = 128°, Figs. 9A and 9B are graph diagrams showing the propagation characteristic of the boundary elastic wave in a case of θ = 129°, Figs. 10A and 10B are graph diagrams showing the propagation characteristic of the boundary elastic wave in a case of θ = 130°, Figs. 11A and 11B are graph diagrams showing the propagation characteristic of the boundary elastic wave in a case of θ = 131°, and Figs. 12A and 12B are graph diagrams showing the propagation characteristic of the boundary elastic wave in a case of θ = 132°.

As shown by Fig. 1 and Fig. 2, the boundary elastic wave resonator according to the first embodiment is a one opening resonator, and is constructed by a constitution the same as that of a surface elastic wave resonator of a background art except presence of two kinds of films formed above a comb-shaped electrode. That is, two comb-shaped IDT's (comb-shaped electrodes) 14 are patterned on a surface of a θYX-LN single-crystal piezoelectric substrate (first medium) 1 by a metal film whose major component is aluminum. Respective IDT's 14 are constituted by bus bars 2 and electrode fingers 3, and a high frequency signal is applied between two IDT's 14 the electrode fingers 3 of which are inserted to each other. An interval S of a predetermined width is provided between the contiguous electrode fingers 3. Reflectors 4a, and 4b formed by metal films whose major component is aluminum are installed on both sides of IDT 14. A silicon oxide film (second medium) 5 is formed above IDT's 14 and the reflectors 4a, and 4b, and an aluminum nitride film (third medium) 6 is formed above the silicon oxide film 5.

A film thickness of the electrode finger 3 constituting IDT 14 is, for example, 0.070 $\mu$m, a line width L of the electrode finger 3 is, for example, 0.5 $\mu$m, an interval S of the electrode fingers is, for example, 0.5 $\mu$m, an electrode pitch (a period of the electrode finger 3)$\lambda$ is, for example, 2 $\mu$m, and a number of pairs of the electrode fingers 3 is, for example, 100 pairs. Further, an opening length is, for example, 10$\lambda$. Further, a film thickness of the silicon oxide film 5 is, for example, 1.4 $\mu$m, and a film thickness of the aluminum nitride film 6 is, for example, 6 $\mu$m.

A characteristic of the boundary elastic wave resonator according to the first embodiment resides in that a 3 media structure of the $\theta$YX-LN single-crystal piezoelectric substrate 1, the silicon oxide film 5, and the aluminum nitride film 6 is constituted, the medium to which the boundary elastic wave is confined (silicon oxide film 5), and the medium of carrying out a transformation of an electric signal and a mechanical signal ($\theta$YX-LN single-crystal piezoelectric substrate 1) are divided, a non-piezoelectric and nonmetallic film is used for the medium to which the boundary elastic wave is confined, and the film thickness of the silicon oxide film 5, and a cut angle or the like are made to fall in predetermined ranges as described below. Further, the present invention is not naturally limited with regard to the structure or a number of pieces of IDT's 14, or the film thickness of the electrode finger 3.

Next, an explanation will be given of a method of calculating the propagation characteristic of the boundary elastic wave of the boundary elastic wave device according to the first embodiment by using a technology of simulating the boundary elastic wave resonator.

First, as shown by Fig. 3, the film thickness of the electrode finger 3 of the boundary elastic wave resonator is designated by notation $h_m$, the line width of the electrode finger 3 is designated by notation L, the interval between the electrode finger 3 is designated by notation S, the film thickness of the silicon oxide film 5 is designated by notation $h_1$, the film thickness of the aluminum nitride film 6 is designated by notation $h_2$, and an amount of undulations of an interface 7 is designated by notation $h_\Delta$, and the wave length of the boundary elastic wave excited (coinciding with the electrode pitch) is defined as $\lambda$.

The interface 7 of the silicon oxide film 5 and the aluminum nitride film 6 is undulated depending on the film thickness $h_m$ of the electrode finger 3. Therefore, here, the film thickness $h_1$ of the silicon oxide film 5 is defined by a distance from an upper face of the electrode finger 3 to the bottommost face of the interface 7, and the film thickness $h_2$ of the aluminum nitride film 6 is defined by a distance from the topmost face of the interface 7 to the bottommost face of a surface of the aluminum nitride film 6.

A resonance frequency of the boundary elastic wave resonator is determined by a ratio of a propagation speed of the boundary elastic wave to the electrode pitch $\lambda$. A sound speed of the boundary elastic wave present above the $\theta$YX-LN single-crystal piezoelectric substrate 1 is around 4300 m/s, and the electrode pitch $\lambda$ becomes about 2 $\mu$m at 2GHz band. The line width L of the electrode finger 3 and the interval S of the electrode fingers 3 can comparatively freely be set at this occasion. However, in consideration of a mass production performance, it is preferable that both of the line width L of the electrode finger 3 and the interval S of the electrode finger 3 are large. That is, when the line width L of the electrode finger 3 and the interval S of the electrode finger 3 are 0.5 $\mu$m, a minimum working dimension becomes the largest, which is excellent in the mass production performance.

The propagation loss of the boundary elastic wave is strongly effected with an influence of the interval S of the electrode fingers 3. For example, according to a calculation method described in Non-patent document 1 described above, the electrodes are approximated by a uniform metal film. Therefore, there pose problems that a total weight of the electrodes are doubled, and a mass load is excessively taken in, that reflection/local presence of the boundary elastic wave at end portions of the electrode fingers 3 cannot be taken into consideration, that a shape of the interface 7 of the silicon oxide film 5 and the aluminum nitride film 6 cannot be taken into consideration and the like. Hence, the inventors have investigated the propagation characteristic of the boundary elastic wave in details by taking all the effects of a shape of IDT 14 and the like into consideration by using a technology of simulating the boundary elastic wave resonator described in Patent document 1, mentioned above.

Meanwhile, in order to obtain an elastically high Q value requested in the boundary elastic wave device in recent times, an amount of undulations of a surface of the silicon oxide film 5 generated in a film forming step of the silicon oxide film 5 by using a film forming apparatus on sale, in other words, a size of the undulation amount $h_\Delta$ of the interface 7 cannot be disregarded.

Hence, the inventors have paid attention to the fact that in an actual boundary elastic wave resonator, an elastic characteristic is shown between a shape when the undulation amount $h_\Delta$ of the interface 7 is 0 ($h_\Delta = 0$) and a shape when the undulation amount $h_\Delta$ of the interface 7 is $h_m$ ($h_\Delta = h_m$) because the undulation amount $h_\Delta$ of the interface 7 is changed in a range of $0 < h_\Delta < h_m$ by a film forming condition of the silicon oxide film 5, and paid attention to the fact that the smaller the undulation amount $h_\Delta$ of the interface 7, the lower the loss. Further, as shown by Fig. 4, values of the cut angle $\theta$ and $h_1/\lambda$ improving the Q value are calculated in $h_\Delta = h_m$ which is the worst condition. By using a result of these, it is not necessary to use a special film forming condition or a special film forming apparatus for forming the silicon oxide film 5 and the aluminum nitride film 6, and therefore, the boundary elastic wave resonator can easily be fabricated.

Otherwise, in order to achieve the high Q value, it is necessary to take also a deterioration in a film quality of a wave guide film into consideration. Further, it is preferable that the boundary elastic wave resonator achieves the high Q value in both of a series resonance frequency and a parallel resonance frequency. The inventors have evaluated the boundary elastic wave in Q values at frequencies of both ends thereof, that is, the series resonance Q and the parallel resonance Q by taking these points into consideration.

Further, the silicon oxide film 5 formed by the film forming apparatus is normally a porous film. As a parameter of evaluating a film quality of the porous film, a density reduction rate $\delta$ described in Patent document 1, mentioned above, was used. Elastic constants $C_{11}$, $C_{44}$ and a density p of the silicon oxide film 5 are represented as follows.

$$C_{11} = Co_{11} \times e^{-3} \times \delta$$

$$C_{44} = Co_{44} \times e^{-3.9} \times \delta$$

$$p = po \times (1 - \delta)$$

Here, values of elastic constants and a density of quartz glass which is the densest silicon oxide are used for $Co_{11}$, $Co_{44}$, and po.

The density reduction rate $\delta$ of the silicon oxide film 5 can substantially be made to be small as about $\delta = 0.015$ by forming the silicon oxide film 5 by a sputtering method by optimizing a film forming temperature and a gas rate. The inventors have investigated the boundary elastic wave in a case of the density reduction rate $\delta = 0.015$ by taking the point into consideration. Further, a ratio of the line width L of the electrode finger 3 to the interval S of the electrode finger 3 is made to be 1.

A resonance characteristic of the boundary elastic wave of the boundary elastic wave device is calculated by the technology of simulating the boundary elastic wave resonator by taking the film thickness $h_m$ of the electrode finger 3, the film thickness $h_1$ of the silicon oxide film 5, the cut angle $\theta$, the density reduction rate $\delta$ of the silicon oxide film 5, and the undulation amount $h_\Delta$ of the interface 7 defined as described above into consideration. An example of the result is shown in Fig. 5A through Fig. 12B. Fig. 5A through Fig. 12B show a result of calculating a range of $h_1/\lambda$ at which resonance/anti-resonance satisfy a condition of $1/Q \leq 0.0001$ by changing the cut angle $\theta$ in a case of $\delta = 0.015$ and $h_m/\lambda = 8\%$.

In a case of $\theta = 125°$ shown in Figs. 5A and 5B, the series resonance Q is equal to or larger than 10000 in $55\% \leq h_1/\lambda \leq 73\%$. Further, the parallel resonance Q is equal to or larger than 10000 in $20\% \leq h_1/\lambda \leq 45\%$. k2 is larger than 2% in all of $h_1/\lambda$.

In a case of $\theta = 126°$ shown in Figs. 6A and 6B, the series resonance Q is equal to or larger than 10000 in $59\% \leq h_1/\lambda \leq 83\%$. Further, the parallel resonance Q is equal to or larger than 10000 in $20\% \leq h_1/\lambda \leq 45\%$. k2 is larger than 2% in all of $h_1/\lambda$.

In a case of $\theta = 127°$ shown in Figs. 7A and 7B, the series resonance Q is equal to or larger than 10000 in $63\% \leq h_1/\lambda \leq 100\%$. Further, the parallel resonance Q is equal to or larger than 10000 in $20\% \leq h_1/\lambda \leq 47\%$ and in $87\% \leq h_1/\lambda \leq 100\%$. k2 is larger than 2% in all of $h_1/\lambda$.

In a case of $\theta = 128°$ shown in Figs. 8A and 8B, the series resonance Q is equal to or larger than 10000 in $67\% \leq h_1/\lambda \leq 100\%$. Further, the parallel resonance Q is equal to or larger than 10000 in all of $h_1/\lambda$ ($20\% \leq h_1/\lambda \leq 100\%$). k2 is larger than 2% in all of $h_1/\lambda$.

In a case of $\theta = 129°$ shown in Figs. 9A and 9B, the series resonance Q is equal to or larger than 10000 in $75\% \leq h_1/\lambda \leq 100\%$. Further, the parallel resonance Q is equal to or larger than 10000 in all of $h_1/\lambda$ ($20\% \leq h_1/\lambda \leq 100\%$). k2 is larger than 2% in all of $h_1/\lambda$.

In a case of $\theta = 130°$ shown in Figs. 10A and 10B, the series resonance Q is equal to or larger than 10000 in $85\% \leq h_1/\lambda \leq 100\%$. Further, the parallel resonance Q is equal to or larger than 10000 in $20\% \leq h_1/\lambda \leq 75\%$. k2 is larger than 2% in all of $h_1/\lambda$.

In a case of $\theta = 131°$ shown in Figs. 11A and 11B, the series resonance Q is equal to or larger than 10000 in $93\% \leq h_1/\lambda \leq 100\%$. Further, the parallel resonance Q is equal to or larger than 10000 in $20\% \leq h_1/\lambda \leq 61\%$. k2 is larger than 2% in all of $h_1/\lambda$.

In a case of $\theta = 132°$ shown in Figs. 12A and 12B, the series resonance Q is equal to or larger than 10000 in $95\% \leq h_1/\lambda \leq 100\%$. Further, the parallel resonance Q is equal to or larger than 10000 in $33\% \leq h_1/\lambda \leq 57\%$. k2 is larger than 2% in all of $h_1/\lambda$.

Although evaluation points in Fig. 5A through Fig. 12B are discrete, the Q values and k2 are continuously changed with regard to the parameters, and therefore, the Q values can easily be known by an interpolation even between the evaluation points.

In this way, according to the first embodiment, by optimizing the film thickness $h_1$ of the silicon oxide film 5 and the cut angle $\theta$ or the like by using the θYX-LN single-crystal,piezoelectric substrate 1 having the predetermined cut angle $\theta$, the boundary elastic wave device having the high quality factor (Q value is equal to or larger than several thousands) and k2 of 2 through 6% can be provided. Further, a general purpose fabrication apparatus or the like can be used in fabricating the boundary elastic wave resonator, and therefore, the boundary elastic wave device can easily be fabricated.

Second Embodiment

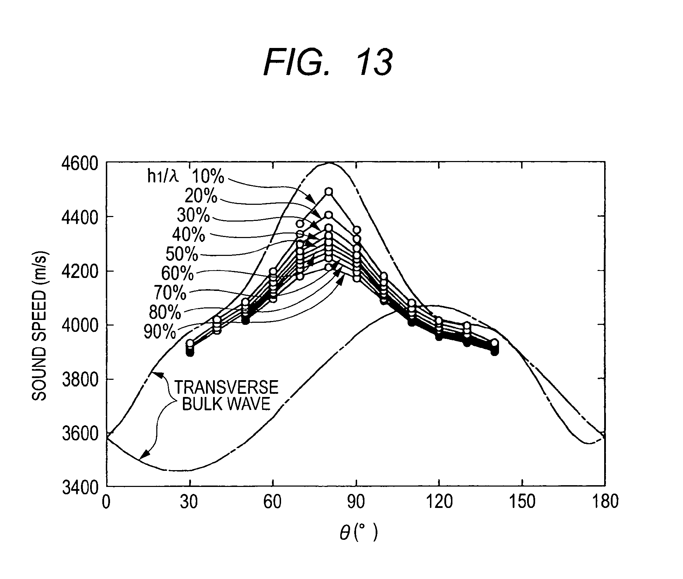

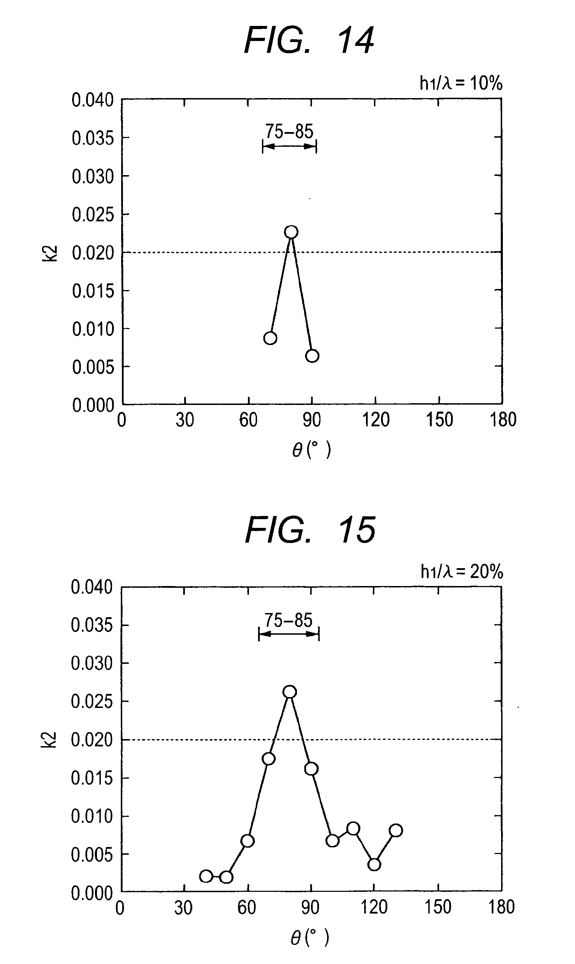

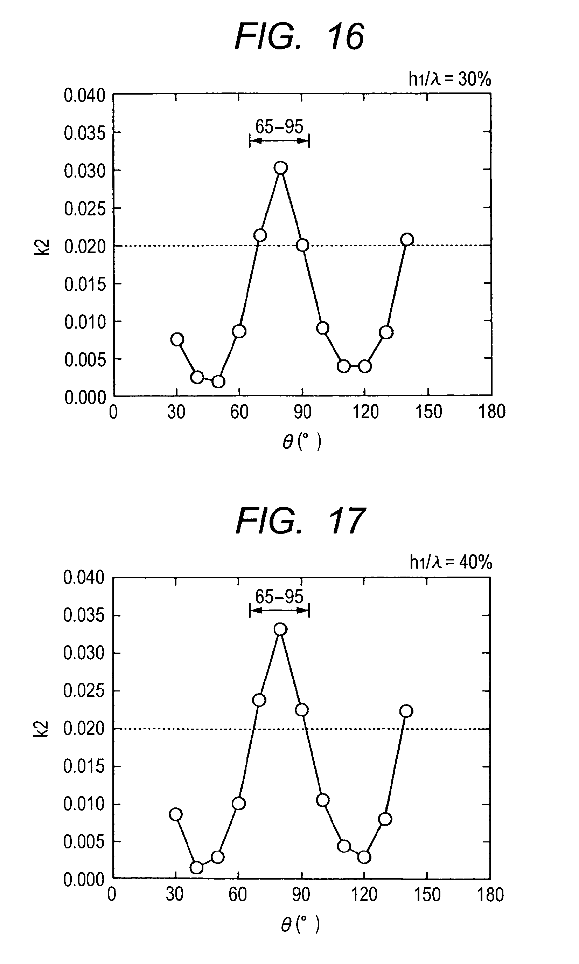

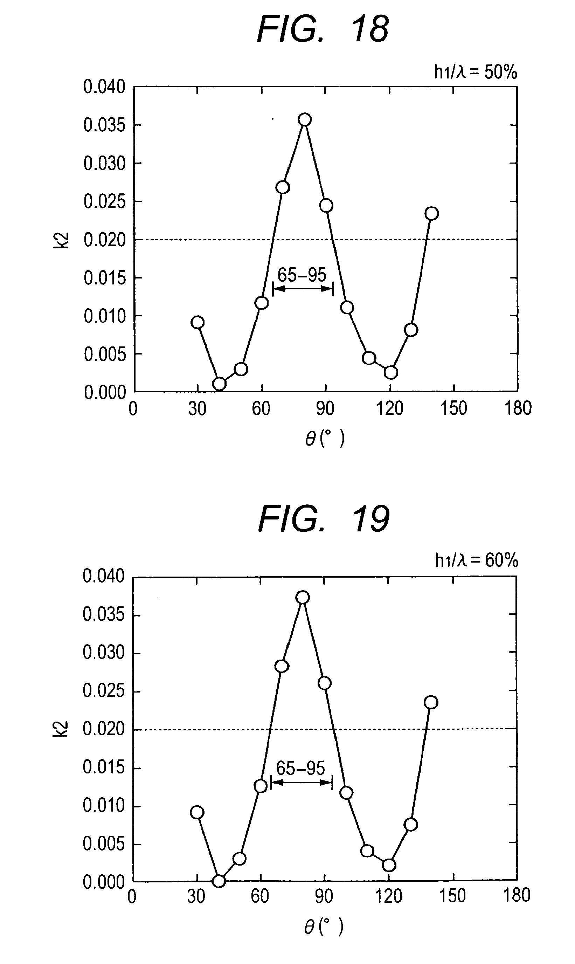

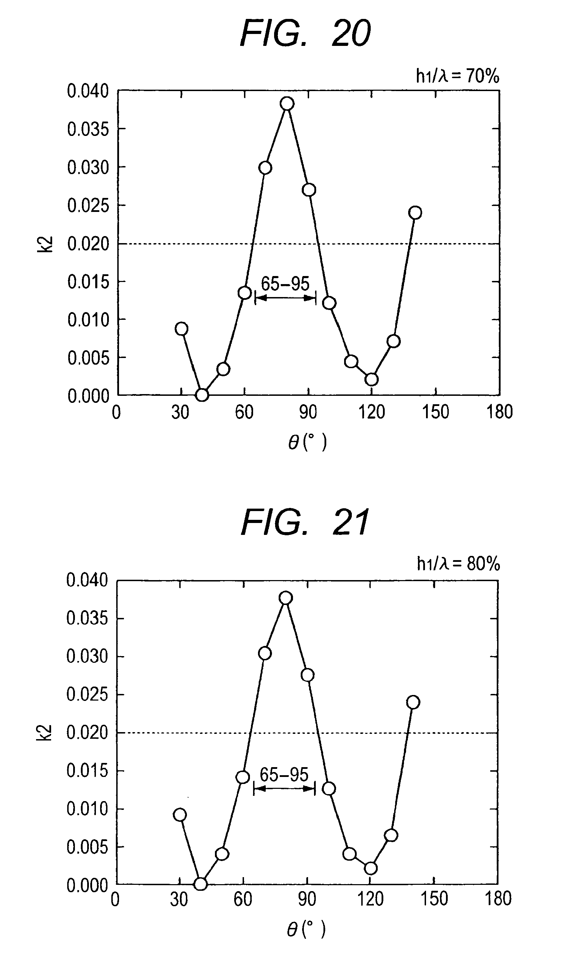

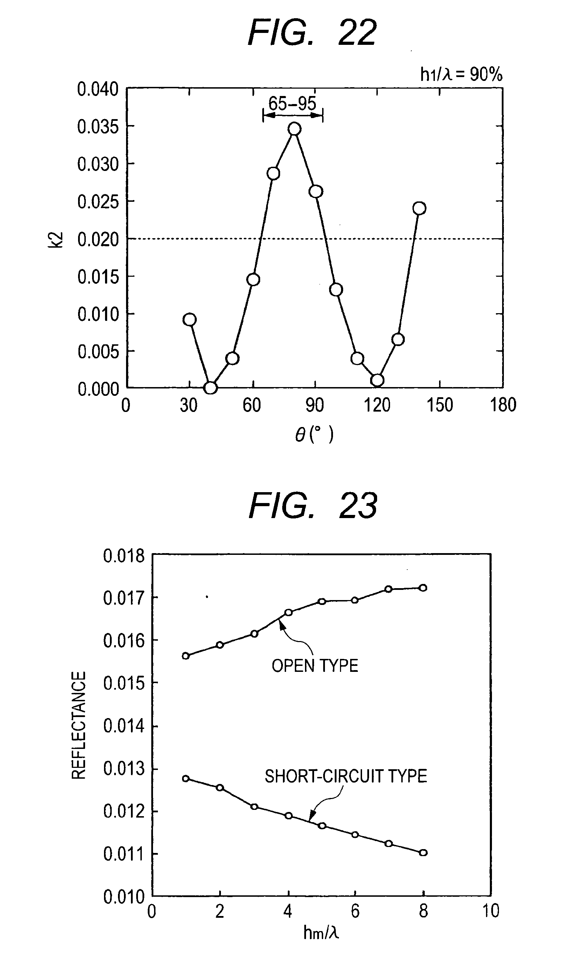

An explanation will be given of a boundary elastic wave device according to the second embodiment in reference to Fig. 13 through Fig. 23. Fig. 13 is a graph diagram showing a range of $h_1/\lambda$ and a cut angle $\theta$ at which a boundary elastic wave is present. Fig. 14 is a graph diagram showing k2 of a boundary elastic wave in a case of $h_1/\lambda$ = 10%. Fig. 15 is a graph diagram showing k2 of a boundary elastic wave in a case of $h_1/\lambda$ = 20%. Fig. 16 is a graph diagram showing k2 of a boundary elastic wave in a case of $h_1/\lambda$ = 30%. Fig. 17 is a graph diagram showing k2 of a boundary elastic wave in a case of $h_1/\lambda$ = 40%. Fig. 18 is a graph diagram showing k2 of a boundary elastic wave in a case of $h_1/\lambda$ = 50%. Fig. 19 is a graph diagram showing k2 of a boundary elastic wave in a case of $h_1/\lambda$ = 60%. Fig. 20 is a graph diagram showing k2 of a boundary elastic wave in a case of $h_1/\lambda$ = 70%. Fig. 21 is a graph diagram showing k2 of a boundary elastic wave in a case of $h_1/\lambda$ = 80%. Fig. 22 is a graph diagram showing k2 of a boundary elastic wave in a case of $h_1/\lambda$ = 90%. Fig. 23 is a graph diagram comparing a reflectance of a short-circuit type reflector and a reflectance of an open type reflector.

A boundary elastic wave resonator according to the second embodiment is constructed by a constitution the same as that of the boundary elastic wave resonator according to the first embodiment, mentioned above, except using a substrate whose major component is lithium niobate piezoelectric single crystal, which is cut in $\theta$ rotation Y cut, and in which a propagation direction of an elastic wave is made to be a direction orthogonal to X-axis (hereinafter, abbreviated as $\theta$YZ'-LN single-crystal piezoelectric substrate).

A characteristic of the boundary elastic wave resonator according to the second embodiment resides in that a 3 media structure of the $\theta$YZ'-LN single-crystal piezoelectric substrate, a silicon oxide film, and an aluminum nitride film is constituted, a medium to which the boundary elastic wave is confined (silicon oxide film), and a medium of carrying out a transformation of an electric signal and a mechanical signal ($\theta$YZ'-LN single-crystal piezoelectric substrate) are divided, a non-piezoelectric and nonmetallic film is used for the medium to which the boundary elastic wave is confined, a film thickness of the silicon oxide film, and a cut angle or the like are made to fall in predetermined ranges described below. The present invention is not naturally limited with regard to a structure or a number of pieces of IDT, or a film thickness of an electrode finger.

Next, an explanation will be given of an example of a propagation characteristic of a boundary elastic wave of a boundary elastic wave device obtained by a technology of simulating a boundary elastic wave resonator.

Fig. 13 is a graph diagram showing ranges of $h_1/\lambda$ and a cut angle $\theta$ at which a boundary elastic wave in which both of Q values at a series resonance point and a parallel resonance point become equal to or larger than 10000 is present in a case of $\delta$ = 0.00 and $h_m/\lambda$ = 4%. The ordinate designates a sound speed, in a case where the boundary elastic wave is present, a sound speed thereof is indicated by a circle (o) mark. For comparison, Fig. 13 describes sound speeds of 2 pieces of transverse bulk waves by one-dotted broken lines. As shown by Fig. 13, a range of the cut angle $\theta$ in which a boundary elastic wave of a gradually high Q value is present is widened as $h_1/\lambda$ becomes large. Further, all of the boundary elastic waves described in Fig. 13 are Stoneley wave type boundary elastic waves, and a leakage boundary elastic wave of a high Q value, and k2 > 2% was not present.

Fig. 14 through Fig. 22 are graph diagrams showing a cut angle $\theta$ dependency of k2 of the boundary elastic wave.

In a case of $h_1/\lambda$ = 10% shown in Fig. 14, k2 is equal to or larger than 2% in $75° \leq \theta \leq 85°$. Further, both of the series resonance Q and the parallel resonance Q are equal to or larger than 10000 in $65° \leq \theta \leq 95°$.

In a case of $h_1/\lambda$ = 20% shown in Fig. 15, k2 is equal to or larger than 2% in $75° \leq \theta \leq 85°$. Further, both of the series resonance Q and the parallel resonance Q are equal to or larger than 10000 in $35° \leq \theta \leq 135°$.

In a case of $h_1/\lambda$ = 30% shown in Fig. 16, k2 is equal to or larger than 2% in $65° \leq \theta \leq 95°$. Further, both of the series resonance Q and the parallel resonance Q are equal to or larger than 10000 in $25° \leq \theta \leq 145°$.

In a case of $h_1/\lambda$ = 40% shown in Fig. 17, k2 is equal to or larger than 2% in $65° \leq \theta \leq 95°$. Further, both of the series resonance Q and the parallel resonance Q are equal to or larger than 10000 in $25° \leq \theta \leq 145°$.

In a case of $h_1/\lambda$ = 50% shown in Fig. 18, k2 is equal to or larger than 2% in $65° \leq \theta \leq 95°$. Further, both of the series resonance Q and the parallel resonance Q are equal to or larger than 10000 in $25° \leq \theta \leq 145°$.

In a case of $h_1/\lambda$ = 60% shown in Fig. 19, k2 is equal to or larger than 2% in $65° \leq \theta \leq 95°$. Further, both of the series resonance Q and the parallel resonance Q are equal to or larger than 10000 in $25° \leq \theta \leq 145°$.

In a case of $h_1/\lambda$ = 70% shown in Fig. 20, k2 is equal to or larger than 2% in $65° \leq \theta \leq 95°$. Further, both of the series resonance Q and the parallel resonance Q are equal to or larger than 10000 in $25° \leq \theta \leq 145°$.

In a case of $h_1/\lambda$ = 80% shown in Fig. 21, k2 is equal to or larger than 2% in $65° \leq \theta \leq 95°$. Further, both of the series resonance Q and the parallel resonance Q are equal to or larger than 10000 in $25° \leq \theta \leq 145°$.

In a case of $h_1/\lambda$ = 90% shown in Fig. 22, k2 is equal to or larger than 2% in $65° \leq \theta \leq 95°$. Further, both of the series resonance Q and the parallel resonance Q are equal to or larger than 10000 in $25° \leq \theta \leq 145°$.

Although evaluation points in Fig. 14 through Fig. 22 are discrete, the Q value and k2 are continuously changed with regard to the parameters, and therefore, the Q value can easily be known by an interpolation even between the evaluation points.

In this way, according to the second embodiment, the boundary elastic wave device having the high quality factor (Q value is equal to or larger than several thousands), and k2 of 2 through 6% can be provided by using the $\theta$YZ'-LN single-crystal piezoelectric substrate having the predetermined cut angle $\theta$.

Further, it is preferable that a direction of C-axis of a crystal of the aluminum nitride film is random. This is for preventing an SH (Shear Horizontal) wave component which is a major component of a mechanical vibration generated by IDT from being transformed into an SV (Shear Vertical) wave component at inside of the aluminum nitride film 6. Therefore, a quite similar effect is achieved even by a film in an amorphous state. Further, even in an oriented film or a single-crystal film, in a case where C-axis of the aluminum nitride film 6 is substantially orthogonal to a substrate face, the SV component and the SH component are orthogonal to each other, and therefore, a similar effect is achieved. The same goes with also the silicon oxide film.

Further, in a case where $h_2/2$ is smaller than a half of the wave length $\lambda$ of the boundary elastic wave, a mechanical vibration energy of a surface of the aluminum nitride film is present, and therefore, the surface elastic wave is excited. The mechanical vibration energy of the surface of the surface elastic wave is extremely smaller than the mechanical vibration energy of the surface of the surface elastic wave of the background art, and therefore, the mechanical vibration energy is partially provided with an excellent characteristic of the boundary elastic wave. For example, a deterioration in an electric property of a loss, a frequency shift or the like is smaller with regard to a damage of the surface of the aluminum nitride film or an adherence of impurities by a mistake in handling. Thereby, when the present invention is applied to the surface elastic wave device, the surface elastic wave device which is more highly reliable than the surface elastic wave device of the background art can be provided. However, as the aluminum nitride film is thinned, the propagation loss caused by the damage or the impurity is gradually increased, and therefore, it is preferable to make the aluminum nitride film sufficiently thick above the resonator.

Further, although in the piezoelectric boundary elastic wave device according to the second embodiment, IDT is formed by a metal whose major component is aluminum, an electrode material is not limited to aluminum. A similar effect is achieved even by an alloy mixing copper, silicon, titanium or the like to aluminum, or a multilayer film of these. By using a metal having a small density whose major component is aluminum, a dispersion in an operational frequency of the boundary elastic wave device caused by a dispersion in fabrication of the film thickness of the metal film, a work dimension or the like can be made to be small.

Fig. 23 shows a graph diagram comparing a reflectance of an open type reflector and a reflectance of a short-circuit type reflector. The cut angle $\theta$ of the both is 128°, further, a material of the reflectors is aluminum. The open type reflector shows a reflectance larger than that of the short-circuit type reflector in all of the film thicknesses. Therefrom, in a boundary elastic wave of a leakage type having the cut angle $\theta$ near to 128°, an effective reflection band width can be made to be large by using the short-circuit type reflector. That is, although the reflectors 4a, and 4b of the open type reflector having larger reflectance are used in the boundary elastic wave resonator explained in the first embodiment, mentioned above, by using the short-circuit type reflector, the boundary elastic wave resonator having a smaller loss can be provided.

Although a specific explanation has been given of the present invention which has been achieved by the inventors based on the embodiments as described above, the present invention is not limited to the above-described embodiments, but can naturally be changed variously within a range not deviated from a gist thereof.

For example, although in the first and the second embodiments described above, an explanation has been given by taking an example of the aluminum nitride film as the medium of confining the boundary elastic wave, the same characteristic and effect can be achieved so far as the medium is a nitride film whose major component is a nitride substance, or an oxide film whose major component is an oxide substance having a high sound speed.

The present invention can be applied to an elastic wave device used in a solid circuit element of a resonator, a filter or the like of a communication apparatus for a high frequency.

## Claims

1. An elastic wave device comprising:

   a first medium whose major component is a lithium niobate piezoelectric single crystal, and which has a plane cut out in $\theta$ rotation Y cut;
   a third medium whose major component is a nitride substance;
   a second medium which is interposed between the first medium and the third medium, and whose major component is silicon oxide; and
   a cross finger type transducer and a reflector interposed between the first medium and the second medium, and formed above the plane of the first medium, the cross finger type transducer being an elastic wave device mainly exciting a boundary elastic wave,
   wherein when a wave length of the boundary elastic wave is designated by a notation $\lambda$, a thickness of the second medium is designated by a notation $h_1$, and a thickness of the cross finger type transducer is designated by a notation $h_m$, an inequality of $1\% \leq h_m/\lambda \leq 8\%$ is established, and the elastic wave device is conformed to one of a group of inequalities shown below:

   $124.5° \leq \theta < 125.5°$ and $20\% \leq h_1/\lambda \leq 45\%$,
   $125.5° \leq \theta < 126.5°$ and $20\% \leq h_1/\lambda \leq 45\%$,

$126.5° \leq \theta < 127.5°$ and $20\% \leq h_1/\lambda \leq 47\%$,
$126.5° \leq \theta < 127.5°$ and $87\% \leq h_1/\lambda \leq 100\%$,
$127.5° \leq \theta < 128.5°$ and $20\% \leq h_1/\lambda \leq 100\%$,
$128.5° \leq \theta < 129.5°$ and $20\% \leq h_1/\lambda \leq 100\%$,
$129.5° \leq \theta < 130.5°$ and $20\% \leq h_1/\lambda \leq 75\%$,
$130.5° \leq \theta < 131.5°$ and $20\% \leq h_1/\lambda \leq 61\%$, and
$131.5° \leq \theta \leq 132.5°$ and $33\% \leq h_1/\lambda \leq 57\%$.

2. An elastic wave device comprising:

a first medium whose major component is a lithium niobate piezoelectric single crystal, and which has a plane cut out in $\theta$ rotation Y cut;
a third medium whose major component is a nitride substance;
a second medium which is interposed between the first medium and the third medium, and whose major component is silicon oxide; and
a cross finger type transducer and a reflector interposed between the first medium and the second medium, and formed above the plane of the first medium;
wherein the cross finger type transducer is an elastic wave device mainly exciting a boundary elastic wave, and
wherein when a wave length of the boundary elastic wave is designated by a notation $\lambda$, a thickness of the second medium is designated by a notation $h_1$, and a thickness of the cross finger type transducer is designated by a notation $h_m$, an inequality of $1\% \leq h_m/\lambda \leq 8\%$ is established, and the elastic wave device is conformed to one of a group of inequalities shown below:

$124.5° \leq \theta < 125.5°$ and $55\% \leq h_1/\lambda \leq 73\%$,
$125.5° \leq \theta < 126.5°$ and $59\% \leq h_1/\lambda \leq 83\%$,
$126.5° \leq \theta < 127.5°$ and $63\% \leq h_1/\lambda \leq 100\%$,
$127.5° \leq \theta < 128.5°$ and $67\% \leq h_1/\lambda \leq 100\%$,
$128.5° \leq \theta < 129.5°$ and $75\% \leq h_1/\lambda \leq 100\%$,
$129.5° \leq \theta < 130.5°$ and $85\% \leq h_1/\lambda \leq 100\%$,
$130.5° \leq \theta < 131.5°$ and $93\% \leq h_1/\lambda \leq 100\%$, and
$131.5° \leq \theta \leq 132.5°$ and $95\% \leq h_1/\lambda \leq 100\%$.

3. An elastic wave device comprising:

a first medium whose major component is a lithium niobate piezoelectric single crystal, and which has a plane cut out in $\theta$ rotation Y cut;
a third medium whose major component is a nitride substance;
a second medium which is interposed between the first medium and the third medium, and whose major component is silicon oxide; and
a cross finger type transducer and a reflector interposed between the first medium and the second medium, and formed above the plane of the first medium, the cross finger type transducer being an elastic wave device mainly exciting a boundary elastic wave,
wherein when a wave length of the boundary elastic wave is designated by a notation $\lambda$, a thickness of the second medium is designated by a notation $h_1$, and a thickness of the cross finger type transducer is designated by a notation $h_m$, an inequality of $1\% \leq h_m/\lambda \leq 8\%$ is established, and the elastic wave device is conformed to one of a group of inequalities shown below:

$5\% \leq h_1/\lambda < 15\%$ and $65° \leq \theta \leq 95°$,
$15\% \leq h_1/\lambda < 25\%$ and $35° \leq \theta \leq 135°$, and
$25\% \leq h_1/\lambda \leq 5\%$ and $25° \leq \theta \leq 145°$.

4. The elastic wave device according to claim 3, wherein the elastic wave device is further conformed to one of a group of inequalities shown below:

$5\% \leq h_1/\lambda < 25\%$ and $75° \leq \theta \leq 85°$, and
$25\% \leq h_1/\lambda \leq 95\%$ and $65° \leq \theta \leq 95°$.

5. The elastic wave device according to claim 1, wherein the cross finger type transducer is constituted by a metal whose major component is aluminum.

6. The elastic wave device according to claim 1, wherein the reflector is an open type reflector.

7. The elastic wave device according to claim 1, wherein the reflector is a short-circuit type reflector.

8. The elastic wave device according to claim 1, wherein a direction of C-axis of a crystal of the third medium is random.

9. The elastic wave device according to claim 1, wherein the third medium is brought into an amorphous state.

10. The elastic wave device according to claim 1, wherein the third medium is an aluminum nitride film.

11. The elastic wave device according to claim 1, wherein the boundary elastic wave is a leakage boundary elastic wave.

12. The elastic wave device according to claim 3, wherein the boundary elastic wave is a non-leakage boundary elastic wave.

# FIG. 1

# FIG. 2

## FIG. 3

## FIG. 4

## FIG. 5A

$\theta = 125°$

## FIG. 5B

$\theta = 125°$

## FIG. 6A

$\theta = 126°$

## FIG. 6B

$\theta = 126°$

## FIG. 7A

## FIG. 7B

## FIG. 8A

## FIG. 8B

# FIG. 9A

# FIG. 9B

## FIG. 10A

θ = 130°

## FIG. 10B

θ = 130°

## FIG. 11A

## FIG. 11B

## *FIG. 12A*

$\theta = 132°$

## *FIG. 12B*

$\theta = 132°$

# FIG. 13

## FIG. 14

$h_1/\lambda = 10\%$

## FIG. 15

$h_1/\lambda = 20\%$

## FIG. 16

## FIG. 17

## FIG. 18

## FIG. 19

## FIG. 20

## FIG. 21

## FIG. 22

$h1/\lambda = 90\%$

## FIG. 23

# FIG. 24

# FIG. 25

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 98052279 A
- JP HEI10199884247 A
- WO 05069485 A
- WO 06114930 A

**Non-patent literature cited in the description**

- **J. J. Campbell ; W. R. Jones.** A method for estimating optical cuts and propagation directions for excitation of piezoelectric surface waves. *IEEE Trans. Sonics and Ultrason.,* 1968, vol. SU-15, 209-217